(19)

**Europäisches Patentamt**
**European Patent Office**
**Office européen des brevets**

(11) **EP 1 845 551 A1**

(12) **EUROPEAN PATENT APPLICATION**
published in accordance with Art. 158(3) EPC

(43) Date of publication:
**17.10.2007 Bulletin 2007/42**

(21) Application number: **05814365.2**

(22) Date of filing: **02.12.2005**

(51) Int Cl.:
*H01J 37/26* (2006.01)    *H01J 37/04* (2006.01)
*H01J 37/295* (2006.01)

(86) International application number:
**PCT/JP2005/022595**

(87) International publication number:
**WO 2006/059803 (08.06.2006 Gazette 2006/23)**

(84) Designated Contracting States:
**DE NL**

(30) Priority: **03.12.2004 JP 2004351902**

(71) Applicant: **Inter-University Research Institute Corporation NA**
**Mitaka-shi, Tokyo 1818588 (JP)**

(72) Inventors:
• **Nagayama, Kuniaki**
**Okazaki-shi,**
**Aichi 444-0874 (JP)**

• **Danev, Radostin**
**Okazaki-shi,**
**Aichi 444-0877 (JP)**

(74) Representative: **Calamita, Roberto**
**Frank B. Dehn & Co.**
**St Bride's House**
**10 Salisbury Square**
**London EC4Y 8JD (GB)**

(54) **PHASE PLATE FOR PHASE-CONTRAST ELECTRON MICROSCOPE, METHOD FOR MANUFACTURING THE SAME AND PHASE-CONTRAST ELECTRON MICROSCOPE**

(57)    A phase plate (10) for phase-contrast electron microscopes is **characterized by** comprising a conductive core phase plate (14) which has a phase plate body (11) and a phase plate support (12) supporting it and is arranged in the path of electrons having passed through the objective lens of an electron microscope and in which the phase plate body (11) is so supported on the phase plate support (12) having an opening (13) as to cover at least a part of the opening (13) and a conductive shield thin film (15) covering the periphery of the core phase plate (14) including the upper and lower sides thereof. Consequently, a phase plane for phase-contrast electron microscopes preventing the lens effect incident to charging completely and applicable to the field of material science, its manufacturing method and a phase-contrast electron microscope can be provided.

Fig. 1

Fig. 1(a)

Fig. 1(b)

EP 1 845 551 A1

**Description**

Technical Field

The present invention concerns a phase plate for use in a phase-contrast electron microscope, a method for manufacturing the same, and a phase-contrast electron microscope. More specifically, the present invention concerns a phase plate for use in a phase-contrast electron microscope capable of preventing the lens effect incident to charging completely and being applicable to the field of material science, a manufacturing method thereof, and a phase-contrast electron microscope.

Background Art

Heretofore, a phase-contrast electron microscope of converting the difference of phase caused to electron beams having transmitted a specimen into the change of intensity and imaging the same has been known. A problem of charging of the phase plate has existed in the phase-contrast electron microscope. Therefore, a relatively less charging carbon thin film has been used as the phase plate. However, contamination of the phase plate by various courses is inevitable even by the use of the carbon thin film, and various proposals to prevent charging have been made such as irradiation of electron beams for a long time to the phase plate just before use (JP-A No. 2001-273866), heating of the phase plate (J. Faget, M. M. Fagot, J. Ferre and C. Fertf, "Microscopie Electronique A contraste dc Phase", Proceedings of 5th International Congress of Electron Microscopy, Academic Press (1962)), and provision of an anti-contamination blade (H. M. Johnson and D. F. Parson, "Enhanced contrast in electron microscopy of unstained biological material", J. Microsc. 98 (1973), p. 1-17).
Since such methods have an antistatic effect to some extent, they have been utilized in the application for biological-specimens not requiring high resolution (R. Danev and K. Nagayama, "Transmission Electron Microscopy with Zernike Phase Plate", Ultramicroscopy 88 (2001), p. 243 - 252).

Disclosure of the Invention

In a case of using a conductive material for the phase plate in the phase-contrast electron microscope, it has been known long since that charging of the phase plate is not caused by the phase plate itself but caused by foreign insulation contamination intruded in the course of manufacturing the phase plate. Among the contaminations, those derived from organic substances are evaporated to some extent in vacuum at a high temperature and those derived from inorganic substances and metal oxides are not eliminated even in vacuum but always remain as the cause of charging. While efforts have been made in various studies for eliminating non-volatile insulation contaminations to prepare a completely clean phase plate, they have not yet been successful. This is because deposition of fine contaminations are inevitable in any way throughout the step of peeling a phase plate from a substrate and transferring the same as a free thin film to a grid (phase plate support) for use in an electron microscope.
Even aluminum considered as a conductive thin film material of excellent antistatic effect can not get out of charging as a problem in the phase-contrast electron microscope. This is because a thin oxide film formed on the surface of aluminum undergoes charging. Such charging induced in the oxide film by electron irradiation bends the trajectory of electron beams, and results in an unnecessary lens effect to distort images. This is because a not-shielded space charge results in a long distance potential in proportion to the reciprocal of the distance. Even when the size of the cause for charging is 1 nm or less, the potential radius prevails to the vicinity of 1 mm which is a million times thereof to deflect the trajectory of the electron beams. The essence of the problem resides in that the space potential induced by static charges forms a sort of a lens to disturb the intrinsic performance of the phase plate.
As described above, none of the methods proposed so far could not completely prevent charging in the phase plate of the phase-contrast electron microscope. Particularly, an effect of image distortion due to charging always appeared to impediments to high resolution (high spatial frequency). Accordingly, attainment of application of the phase-contrast electron microscope in the field of material science requiring high resolution has been retarded in the actual situation.
Then, the present invention has been achieved in view of the foregoing situations and, based on the recognition that prevention of charging to the phase plate is impossible, it is an object thereof to prevent rather the lens effect incident to charging and provide a phase plate for use in a phase-contrast electron microscope capable of application to the field of material science, a method of manufacturing the same, and a phase-contrast electron microscope.
According to a first aspect of the invention, there is provided a phase plate for use in a phase-contrast electron microscope having a phase plate body and a phase plate support for supporting the same and disposed in a path of electrons having passed an objective lens of the electron microscope, in which the phase plate body comprises a conductive core phase plate supported to the phase plate support having an opening so as to cover at least a portion of the opening, and a conductive shielding thin film covering the periphery including both upper and lower surfaces of the core phase plate.

According to a second aspect of the invention, there is provided the phase plate for use in a phase-contrast electron microscope as described in the first invention, wherein the phase plate support is grounded to the earth.

According to a third aspect of the invention, there is provided the phase plate for use in a phase-contrast electron microscope as described in the first or second invention wherein carbon, beryllium, aluminum or silicon, or an alloy thereof is used as the material for the core phase plate.

According to a fourth aspect of the invention, there is provided the phase plate for use in a phase-contrast electron microscope as described in any one of the first to third inventions, wherein carbon, gold, silver, or platinum group is used as the material for the conductive shielding thin film.

According to a fifth aspect of the invention, there is provided the phase plate for use in a phase-contrast electron microscope according to any one of the first to fourth inventions, wherein the phase plate body has a circular planar shape, is formed with a circular electron transmission hole at a central part as a path for electrons, and the film thickness is controlled so as to shift the phase of electrons by $\pi/2$.

According to a sixth aspect of the invention, there is provided the phase plate for use in a phase-contrast electron microscope according to any one of the first to fourth inventions, wherein the phase plate body substantially semi-circular planar shape and the film thickness is controlled so as to shift the phase of electrons by $\pi$.

According to a seventh aspect of the invention, there is provided a phase-contrast electron microscope characterized by comprising a phase plate for use in a phase-contrast electron microscope according to any one of the first to the first to sixth inventions.

According to a eighth aspect of the invention, there is provided a method of manufacturing a phase plate for use in a phase-contrast electron microscope according to any one of first to sixth inventions, wherein a conductive core phase plate is prepared such that it is supported on a phase plate support having an opening so as to cover at least a part of the opening and then covering a conductive shielding thin film to the periphery including both upper and lower surfaces of the core phase plate and a grid to manufacture a phase plate body as a final step.

According to a ninth aspect of the invention, there is provided the method of manufacturing a phase plate for use in a phase-contrast electron microscope according to the eighth invention, wherein the formation for covering the conductive shielding thin film is conducted by using a Joule heat vacuum vapor deposition method, an electron beam vacuum vapor deposition method, an ion sputtering method, or a plasma CVD method.

According to the present invention, the lens effect incident to the charging of the phase plate for use in a phase-contrast electron microscope can be prevented completely, making it possible to apply various types of phase-contrast electron microscopes such as by a Zernike phase contrast method, a differential contrast method, and the like to an extensive field of material science such as metallurgy, semiconductor industries and ceramic industries.

Brief Description of the Drawings

Figs. 1(a) and (b) are cross sectional views schematically showing embodiments of a phase plate for use in a phase-contrast electron microscope according to the present invention in which (a) shows a Zernike phase plate and (b) shows a Hilbert differentiatial phase plate.

Figs. 2(a) and (b) are respectively cross sectional views showing examples of typical shape and size of the existent Zernike phase plate and the Hilbert differential phase plate used in a 100 kV phase-contrast electron microscope.

Figs. 3(a) and (b) are respectively cross sectional views showing examples of typical shape and size of the existent typical Zernike phase plate and the Hilbert differential phase plate used in a 300 kV phase-contrast electron microscope.

Fig. 4 is a view showing a contrast transfer function (CFT indicated by absolute value) of a conventional method (solid line) and a phase-contrast method (broken line), in which the dotted line shows a contrast transfer function (CFT indicated by absolute value) in a case of a charged phase plate.

Figs. 5(a) and (b) are views showing, respectively, the charging characteristic, and a relation between CTF phase shift and spatial frequency of a conventional mono-layer type carbon film Zernike phase plate with no prevention for charging.

Figs. 6(a) and (b) are views showing, respectively, the charging characteristic and a relation between CTF phase shift spatial frequency of a Zernike phase plate according to the present invention.

Best Mode for Carrying Out the Invention

The present invention has the feature as described above and the embodiment thereof will be described.

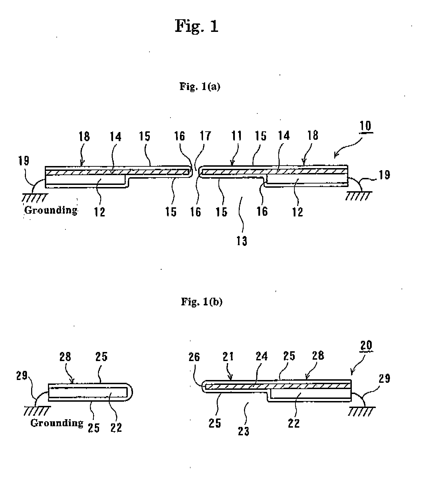

Figs. 1(a) and (b) are, respectively, cross sectional views schematically showing embodiments of a phase plate for use in a phase-contrast electron microscope according to the present invention.

At first, referring to a phase plate (10) shown in Fig. 1(a), the phase plate (10) is referred to as a Zernike phase plate, has a phase plate body (11) and a grid (12) as a phase plate support, and is disposed to the path of electrons having passed through an objective lens of a phase-contrast electron microscope. The phase plate (10) is adapted to shift the phase of electrons by $\pi/2$. The phase plate body (11) comprises a conductive core phase plate (14) supported on the grid (12) having a circular opening (13) and a conductive shielding thin film (15) disposed on both surfaces thereof. A regular circle through hole is formed in the center of the core phase plate (14), a conductive shielding thin film (15) is disposed also to a side wall part (16) thereof and, as a result, a regular circle electron transmission hole (17) is formed. Further, the conductive shielding thin film (15) is disposed also to a grid part (18) as a portion corresponding to the extended portion of the core phase plate (14) disposed on the grid (12) that supports the core phase plate (14). The grid (12) does not allow the electron to transmit therethrough. Accordingly, the phase plate body (11) has the electron transmission hole (17) at the center, basically comprises three layers and is in a circular planar shape. The thickness of the phase plate body (11) is controlled so as to shift the phase of electrons by $\pi/2$. Further, the grid (12) is grounded to the earth by a grounding member (19).

Then, referring to a phase plate (20) shown in Fig. 1(b), the phase plate (20) is referred to as a Hilbert differential phase plate and, like the phase plate (10) in Fig. 1(a), has a phase plate body (21) and a grid (22) as a phase plate support, and is disposed in the pass of electrons having passed an objective lens of a phase-contrast electron microscope. The phase plate (20) is adapted so as to shift the phase of electrons by $\pi$. The phase plate body (21) comprises a substantially semi-circular conductive core phase plate (24) supported on the grid (22) having a circular opening (23) and conductive shielding thin films (25) disposed on both surfaces thereof. The conductive shielding thin film (25) is disposed also to the side wall part (26) of the core phase plate (14). The conductive shielding thin film (25) is disposed to a grid part (28) as a part corresponding to the extended part of the core phase plate (24) disposed on the grid (22) that supports the core phase plate (24), and to the grid (22) on the left in the drawing at the both surfaces and lateral wall surfaces thereof. The grid (22) does not allow electrons to transmit therethrough. Accordingly, the phase plate body (21) basically comprises three layers and is in a substantially semi-circular planar shape. The film thickness of the phase plate body (21) is controlled so as to shift the phase of electrons by $\pi$. Further, the grid (22) is grounded to the earth by a grounding member (29).

As the material for the core phase plates (14), (24), conductive light element materials, for example, carbon, beryllium, aluminum or silicon, or alloys thereof can be used. While the thickness of the core phase plate (14) is properly determined depending on the material, the acceleration voltage, etc., it can be, for example, from about 10 to 15 nm for an acceleration voltage of 100 kV. Further, the diameter of the electron transmission hole (17) can be about from 0.5 to 1 $\mu$m. On the other hand, while the thickness of the core phase plate (24) is properly determined depending on the material, the acceleration voltage, etc. and it can be set, for example, about from 20 to 30 nm for a 100 kV acceleration voltage.

As the materials for the conductive shielding thin films (15), (25), those less oxidizing materials, for example, carbon, gold, silver or platinum groups (ruthenium, rhodium, palladium, osmium, iridium, and platinum) can be used. The thickness of the conductive shielding thin film (15) is also determined properly depending on the material, the acceleration voltage, etc., it can be about from 2 to 10 nm. On the other hand, the thickness of the conductive shielding thin film (25) is also determined properly depending on the material, the acceleration voltage, etc., it can be about from 2 to 10 nm. It is important that the conductive shielding thin films (15), (25) is formed in the final step in the course of manufacturing the phase plate bodies (11), (21).

While the thickness of the phase plate body (11) is controlled so as to shift the phase of the electrons by $\pi/2$ as described above, the entire thickness thereof can be from 15 to 25 nm for a 100 kV acceleration voltage. Further, the diameter of the phase plate body (11) can be about from 50 to 100 $\mu$m.

On the other hand, while the thickness of the phase plate body (21) is controlled so as to shift the phase of the electrons by $\pi$ as described above, the entire thickness thereof can be from 30 to 45 nm for a 100 kV acceleration voltage. Further, the radius of the phase plate body (21) can be about from 25 to 50 $\mu$m.

As the material for the grids (12), (22), conductive materials such as copper and molybdenum can be used. The thickness of each of the grids (12), (22) can be about from 10 to 50 $\mu$m. The shape of each of the grids (12), (22) is typically a ring shape but it is not restricted thereto.

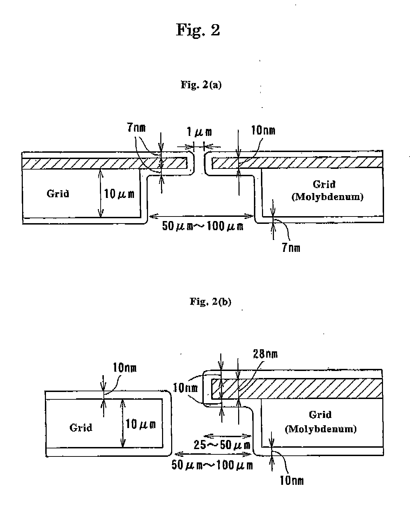

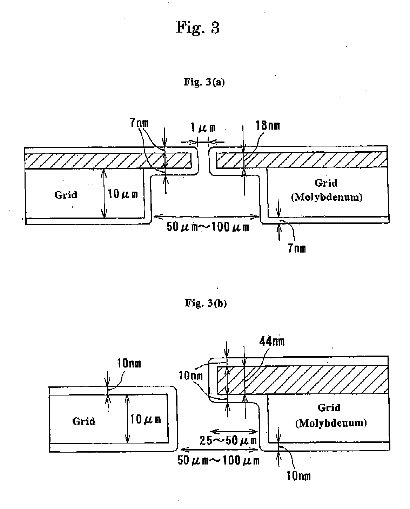

Fig. 2(a) and Fig. 3(a) show examples of typical shape and size of the phase plate (10) used for a 100 kV phase-contrast electron microscope and a 300 kV phase-contrast microscope according to the present invention, and Fig. 2(b) and Fig. 3(b) show examples of typical shape and the size of the phase plate (20) used for a 100 kV phase-contrast electron microscope and a 300 kV phase-contrast microscope according to the present invention.

Then, method of manufacturing the phase plate (10) with the configuration described above will be described.

At first, a material for a core phase plate is deposited to a required thickness on an insulative substrate such as of mica or silicon by a method such as a Joule heat vacuum vapor deposition method, an electron beam vacuum vapor deposition method, an ion sputtering method and a plasma CVD method to form an amorphous core phase plate film (deposition step). This is peeled, for example, in water and floated on the surface of water (peeling step). Then, it is skimmed by a grid (12) comprising a conductive material such as copper or molybdenum formed with a circular opening (13). The entire surface of the opening (13) is covered with the core phase plate film (transfer step). Then, a fine through hole is formed to the center of the core phase plate film (14) by a focused ion beam method (drilling-a-hole step). Then, a conductive shield material is deposited to a required thickness to both surfaces and the side wall part (16) of the through hole of the core phase plate (14) supported on the grid (12) by a Joule heat vacuum deposition method, an electron beam vacuum method, an ion sputtering method, a plasma CVD method, or the like to form an amorphous conductive shielding thin film (15), thereby obtaining a phase plate body (11) having an electron beam transmission hole (17).

In the foregoings, it is important to conduct the step for the conductive shielding thin film (15) as a final step and not apply the drilling-a-hole fabrication for the core phase plate at the last. Further, the grid (12) is grounded to the earth by a grounding member (19) such as a conductive wire.

On the other hand, in a case of manufacturing the phase plate (20), in the same manner as the case of manufacturing the phase plate (10), a material for a core phase plate is at first deposited to a required thickness on an insulative substrate such as of mica or silicon by a method such as a Joule heat vacuum vapor deposition method, an electron beam vacuum vapor deposition method, an ion sputtering method and a plasma CVD method to form an amorphous core phase plate film (deposition step). This is peeled, for example, in water and floated on the surface of water (peeling step). Then, it is skimmed by a grid (22) comprising a conductive material such as copper or molybdenum and formed with a circular opening (23). The entire surface of the opening (23) is covered with the core phase plate film (transfer step). Then, a cutting-out fabrication is applied by a focused ion beam method to form a core phase plate (24) of a substantially semi-circular shape supported on the grid (22) (cutout step). Then, a conductive shield material is deposited to a required thickness to both surfaces and the side walls (26) of the through hole of the core phase plate (24) supported on the grid (22) by a Joule heat vacuum deposition method, an electron beam vacuum method, an ion sputtering method, a plasma CVD method, or the like to form an amorphous conductive shielding thin film (25), thereby obtaining a phase plate body (21) of a substantially semi-circular planar shape.

In the foregoings, it is important to conduct the step for the conductive shielding thin film (25) as a final step and not apply the cutting out fabrication for the core phase plate at the last. Further, the grid (22) is grounded to the earth by a grounding member (29) such as a conductive wire.

When the phase plates (10), (20) are manufactured as described above, since insulation contamination deposited in the course of manufacturing the core phase plate film (each of the steps of deposition, peeling and transfer) and insulation contamination deposited during the drilling-a-hole fabrication and the cutting out fabrication are covered with the conductive shielding thin films (15), (25), charges induced by the electron beams to the contaminated portion are electrically confined. This is the same method as an electromagnetic field shielding. That is, a conductor generally prevents intrusion or leaching of electric fields and, further, charges confined in the conductor are neutralized by the grounding of the conductor. Then, an unnecessary lens effect can be prevented by the electromagnetic field shielding effect. While high conductivity of a shielding body is required in a case of the electromagnetic field shielding, since charges at the contaminated portion do not fluctuate abruptly with time in a case of the phase plate (10) or (20), it is estimated that no high performance as of the metal is not required for the conductivity of the conductive shielding thin films (15), (25).

According to the present invention, a phase-contrast electron microscope using a phase plate having the excellent characteristic as described above is provided.

Then, it will be described how the lens effect incident to charging is prevented by the phase plate for use in a phase-contrast electron microscope according to the present invention by using a model.

In an electron microscope, all images undergo modulation by a contrast transfer function (CTF: hereinafter also simply referred to as CTF). Referring to the same in correspondence to a camera, CTF is a quantitative description of image defocusing. In a case where the focus is displaced, that is, the position of the lens is not correct, images are defocused. As the positional displacement, more correctly, defocusing ($\Delta z$) of a lens is larger, defocus increases. It is expressed by CTF as below.

$$\text{Conventional method CTF} = \sin(\pi\lambda\Delta zk^2) \quad (1)$$

in which $\lambda$ is a wavelength of an electron wave, $\Delta z$ is defocus, and k is a spatial frequency. The spatial frequency k is contained as a variant, because CTF is a function defined by the diffracting plane, that is, by the focal plane behind an objective lens.

On the other hand, CTF according to an ideal phase-contrast method attained by a non-charged Zernike phase plate (λ/4 wavelength plate, having a small aperture at the conter) is given by the following equation:

$$\text{Phase contrast method CTF} = \cos(\pi\lambda\Delta zk^2) \quad (2)$$

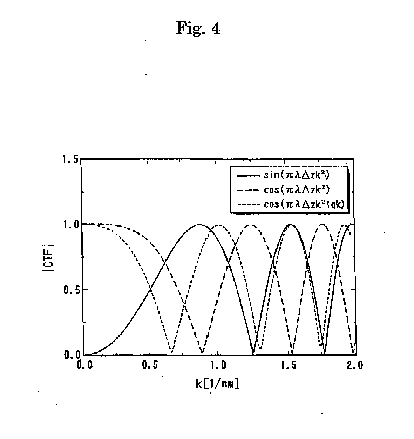

Both of them are illustrated as in Fig. 4. In Fig. 4, a solid line is a case for CTF according to the formula (1) and a broken line is a case according to the formula (2).

However, when the phase plate is charged, a spatial potential is induced to result in a lens effect to add surplus phase component q(k) to the CTF. CTF in this case is represented by the equation (3):

$$\text{Charge phase contrast method CTF} = \cos(\pi\lambda\Delta zk^2 + q(k)) \quad (3)$$

While q(k) is in a complicated shape depending on the charge distribution on the phase plate, the effect is significant even for q(k) = qk in a most simple case of q(k) and CTF changes as shown by the dotted line in Fig. 4. Change of CTF due to the lens effect incident to charging undergoes more effect for high frequency component than low frequency component. This can be understood by comparing cosine type CTF for non-charged (broken line) and charged (dotted line) state shown in Fig. 4.

On the premise of the conceptional model described above, it is shown how the phase plate for use in a phase-contact electron microscope according to the present invention is effective for the solution of the problem of charging with reference to experimental examples.

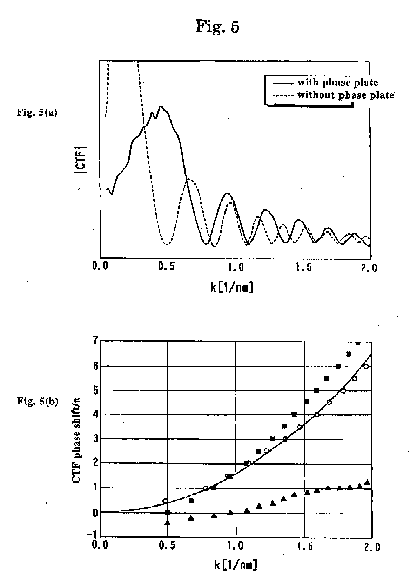

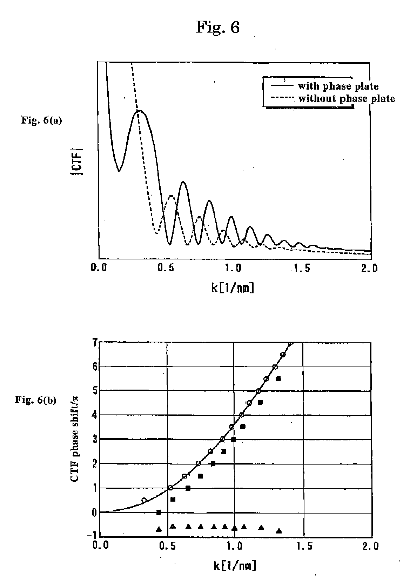

The volumic resistivity, for example, of an amorphous carbon film used for the phase plate is usually $4 \times 10^{-5}$ Ωcm which is thousand times as high as that of a metal such as copper. That is, the electroconductivity is one thousand part of the metal. It has been confirmed that a sufficient shielding effect is present even of a low electroconductivity at such a level by the following experiment (Fig. 5, Fig. 6).

For measurement of the phase change by the phase plate, it was conducted by measuring CTF with or without Zernike phase plate in comparison (Fig. 5(a), Fig. 6(a)). This utilizes that the function type of CTF is a sine type in a case without the phase plate and is a cosine type in a case with the phase plate (already reported in Non-Patent Document 3).

Figs. 5(a), (b) show the result of experiment on the charging characteristic of a conventional type mono-layer carbon film phase plate. Conditions for the phase plate are as described below.

Zernike phase plate for use in 100 kV electron microscope
Material for phase plate body: amorphous carbon
Diameter of phase plate body: 50 μm
Thickness of phase plate body: 24 nm
Diameter of electron beam transmission hole: 1 μm
Material for grid: molybdenum
thickness of grid: 10 μm

Based on the difference of damping oscillations between two CTF plotted in Fig. 5(a), the phase shifting effect of the phase plate is estimated. Based on the damping oscillations in a case with no phase plate (solid line in Fig. 5(a)) and damping oscillations in a case with phase plate (dotted line in Fig. 5(a)), when the phase difference between both of them is plotted in the radial direction, square dots are data with the phase plate and circle dots are data in a case without phase plate as shown in Fig. 5(b). While the phase difference between both of them is indicated by trigonal dots, it is observed that the phase difference which should be at -π/2 is deviated to the positive side toward high frequency (in the direction of right). That is, CTF with phase plate (dotted line) behaves in the same manner as CTF of the charged phase plate model (dotted line) in Fig. 4 to result an additional phase shift.

Figs. 6(a), (b) show the result of experiment on the charging characteristic of a Zernike phase plate according to the present invention. Conditions for the phase plate are as described below.

Zernike phase plate for use in 100 kV electron microscope
Material for core phase plate: amorphous carbon
Thickness of core phase plate: 10 μm
Material for conductive shielding thin film: amorphous carbon
Thickness of conductive shielding thin film: 7 nm
Diameter of phase plate body: 50 μm
Thickness of phase plate body: 24 nm
Diameter of electron beam transmission hole: 1 μm
Material for grid: molybdenum

Thickness of grid: 10 $\mu$m

Based on the difference of damping oscillations between two CTF plotted in Fig. 6(a), the phase shifting effect of the phase plate is estimated. Based on the damping oscillation in a case without phase plate (solid line in Fig. 6(a)) and damping oscillation in a case with the phase plate (dotted line in Fig. 6(a)), when the phase difference between both of them is plotted in the radial direction, square dots are data with the phase plate and circle dots are data without the phase plate, as shown in Fig. 6(b). The phase difference between both of them as shown by trigonal dots. In the case of the phase plate according to the present invention, different from Fig. 5, the phase difference between a case with and without phase plate was about $-\pi/2$ as shown by trigonal dots in Fig. 6(b). Accordingly, it was confirmed that the phase plate according to the present invention possessed favorable characteristic of the Zernike phase plate in a wide range of frequency.

As shown by the result of experiments, in the case of the phase plate with the mono-layer type carbon film of the conventional type, contamination could not be reduced to zero even when it was prepared carefully. On the other hand, in the phase plate according to the present invention, the lens effect incident to contamination charging could be suppressed completely by the conductive shield even when contamination was present.

As described above, while the present invention has been described specifically with reference to the embodiments thereof, it will be apparent that the present invention is not restricted to the embodiment described above but various modes are possible for detailed portions.

**Claims**

1. A phase plate for use in a phase-contrast electron microscope having a phase plate body and a phase plate support for supporting the same and disposed in a path of electrons having passed an objective lens of the electron microscope, in which the phase plate body comprises a conductive core phase plate supported to the phase plate support having an opening so as to cover at least a portion of the opening, and a conductive shielding thin film covering the periphery including both upper and lower surfaces of the core phase plate.

2. The phase plate for use in a phase-contrast electron microscope according to claim 1, wherein the phase plate support is grounded to the earth.

3. The phase plate for use in a phase-contrast electron microscope according to claim 1 or 2, wherein carbon, beryllium, aluminum or silicon, or an alloy thereof is used as the material for the core phase plate.

4. The phase plate for use in a phase-contrast electron microscope according to any one of claims 1 to 3, wherein carbon, gold, silver, or platinum group is used as the material for the conductive shielding thin film.

5. The phase plate for use in a phase-contrast electron microscope according to any one of claims 1 to 4, wherein the phase plate body has a circular planar shape, is formed with a circular electron transmission hole at a central part as a path for electrons, and the film thickness is controlled so as to shift the phase of electrons by $\pi/2$.

6. The phase plate for use in a phase-contrast electron microscope according to any one of claims 1 to 4, wherein the phase plate body substantially semi-circular planar shape and the film thickness is controlled so as to shift the phase of electrons by $\pi$.

7. The phase-contrast electron microscope **characterized by** comprising a phase plate for use in a phase-contrast electron microscope according to any one of claims 1 to 6.

8. A method of manufacturing a phase plate for use in a phase-contrast electron microscope according to any one of claims 1 to 6, wherein a conductive core phase plate is prepared such that it is supported on a phase plate support having an opening so as to cover at least a part of the opening and then covering a conductive shielding thin film to the periphery including both upper and lower surfaces of the core phase plate and a grid to manufacture a phase plate body as a final step.

9. The method of manufacturing a phase plate for use in a phase-contrast electron microscope according to claim 8, wherein the formation for covering the conductive shielding thin film is conducted by using a Joule heat vacuum vapor deposition method, an electron beam vacuum vapor deposition method, an ion sputtering method, or a plasma CVD method.

# Fig. 1

### Fig. 1(a)

### Fig. 1(b)

## Fig. 2

### Fig. 2(a)

```
7nm        1μm      10nm

Grid   10μm              Grid
                      (Molybdenum)

         50μm~100μm
                      7nm
```

### Fig. 2(b)

```
        10nm              28nm

                     10nm
Grid   10μm              Grid
                      (Molybdenum)

        25~50μm
       50μm~100μm
                      10nm
```

## Fig. 3

**Fig. 3(a)**

**Fig. 3(b)**

Fig. 4

Fig. 5

Fig. 5(a)

Fig. 5(b)

## Fig. 6

Fig. 6(a)

Fig. 6(b)

## INTERNATIONAL SEARCH REPORT

International application No.

PCT/JP2005/022595

A.  CLASSIFICATION OF SUBJECT MATTER
*H01J37/26*(2006.01), *H01J37/04*(2006.01), *H01J37/295*(2006.01)

According to International Patent Classification (IPC) or to both national classification and IPC

B.  FIELDS SEARCHED

Minimum documentation searched (classification system followed by classification symbols)
H01J37/26, H01J37/04, H01J37/295

Documentation searched other than minimum documentation to the extent that such documents are included in the fields searched
Jitsuyo Shinan Koho        1922-1996   Jitsuyo Shinan Toroku Koho   1996-2006
Kokai Jitsuyo Shinan Koho  1971-2006   Toroku Jitsuyo Shinan Koho   1994-2006

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| Y | JP 2001-273866 A  (JEOL Ltd.), 05 October, 2001 (05.10.01), Par. Nos. [0018], [0021], [0032] to [0035]; Fig. 1 & US 2002/0011566 A1     & DE 010114949 A1 | 1-9 |
| Y | JP 4-206244 A  (Hitachi, Ltd.), 28 July, 1992 (28.07.92), Page 2, upper right column, lines 2 to 18; upper right column, line 7 to lower left column, line 11; Fig. 2 (Family: none) | 1-9 |
| Y | JP 2000-12419 A  (Toshiba Corp.), 14 January, 2000 (14.01.00), Par. Nos. [0006], [0025], [0031]; Fig. 2 (Family: none) | 1-9 |

☒   Further documents are listed in the continuation of Box C.          ☐   See patent family annex.

| | |
|---|---|
| *      Special categories of cited documents:<br>"A"   document defining the general state of the art which is not considered   to be of particular relevance<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| 30 January, 2006 (30.01.06) | 07 February, 2006 (07.02.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

14

**INTERNATIONAL SEARCH REPORT**

| International application No. |
| --- |
| PCT/JP2005/022595 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | JP 2003-217498 A  (LEO Elektronenmikroskopie GmbH), 31 July, 2003 (31.07.03), Par. No. [0022] & US 2003/0132383 A1    & EP 001329936 A1 & DE 010200645 A | 2-9 |
| Y | JP 2003-100249 A  (JEOL Ltd.), 04 April, 2003 (04.04.03), Par. No. [0007] & US 2003/0066964 A1    & DE 010240859 A | 6-9 |

Form PCT/ISA/210 (continuation of second sheet) (April 2005)

**EP 1 845 551 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001273866 A

**Non-patent literature cited in the description**

- Microscopie Electronique A contraste dc Phase. **J. FAGET ; M. M. FAGOT ; J. FERRE ; C. FERTF.** Proceedings of 5th International Congress of Electron Microscopy. Academic Press, 1962

- **H. M. JOHNSON ; D. F. PARSON.** Enhanced contrast in electron microscopy of unstained biological material. *J. Microsc.,* 1973, vol. 98, 1-17
- **R. DANEV ; K. NAGAYAMA.** Transmission Electron Microscopy with Zernike Phase Plate. *Ultramicroscopy,* 2001, vol. 88, 243-252